Europäisches Patentamt

European Patent Office

Office européen des brevets

(19)

(11) EP 0 514 978 B1

# (12) EUROPEAN PATENT SPECIFICATION

(45) Date of publication and mention
of the grant of the patent:
**22.10.1997 Bulletin 1997/43**

(51) Int Cl.6: **G01R 33/48**

(21) Application number: **92201385.9**

(22) Date of filing: **15.05.1992**

(54) **Magnetic resonance imaging method and device**

Verfahren und Vorrichtung zur Bilderzeugung mittels magnetischer Resonanz

Procédé et dispositif pour la production d'images par résonance magnétique

(84) Designated Contracting States:
**DE FR GB NL**

(30) Priority: **23.05.1991 EP 91201228**

(43) Date of publication of application:
**25.11.1992 Bulletin 1992/48**

(73) Proprietor: **Philips Electronics N.V.**
**5621 BA Eindhoven (NL)**

(72) Inventors:
- **Lamerichs, Rudolf Mathias Johannes Nicolaas**
  **NL-5656 AA Eindhoven (NL)**
- **van Stapele, Reurt Pieter**
  **NL-5656 AA Eindhoven (NL)**
- **den Hollander, Jan Anthonie**
  **NL-5656 AA Eindhoven (NL)**

(74) Representative: **Schouten, Marcus Maria et al**
**INTERNATIONAAL OCTROOIBUREAU B.V.,**
**Prof. Holstlaan 6**
**5656 AA Eindhoven (NL)**

(56) References cited:
**EP-A- 0 347 990        US-A- 4 922 203**

- **JOURNAL OF MAGNETIC RESONANCE. vol. 89, no. 3, 1 October 1990, ORLANDO, MN US pages 533 - 542; E.R.P. ZUIDERWEG: 'ANALYSIS OF MULTIPLE-PULSE-BASED HETERONUCLEAR J CROSS POLARIZATION IN LIQUIDS'**
- **JOURNAL OF MAGNETIC RESONANCE. vol. 86, no. 3, 15 February 1990, ORLANDO, MN US pages 526 - 548; A. KNÜTTEL ET AL.: 'INDIRECT 13C TOMOGRAPHY AND VOLUME-SELECTIVE SPECTROSCOPY VIA PROTON NMR. I. SPECTROSCOPIC TECHNIQUES AND II. IMAGING'**
- **JOURNAL OF MAGNETIC RESONANCE. vol. 83, no. 1, 1 June 1989, ORLANDO, MN US pages 183 - 189; H.N. YEUNG ET AL.: 'IMAGING AND LOCALIZED SPECTROSCOPY OF 13C BY POLARIZATION TRANSFER'**
- **JOURNAL OF MAGNETIC RESONANCE. vol. 83, no. 2, 15 June 1989, ORLANDO, MN US pages 299 - 308; E. ROMMEL ET AL.: 'SLICE EXCITATION AND LOCALIZED NMR SPECTROSCOPY ON THE BASIS OF SPIN LOCKING'**
- **JOURNAL OF MAGNETIC RESONANCE. vol. 91, no. 3, 15 February 1991, ORLANDO, MN US pages 607 - 613; J. FEENEY ET AL.: 'DECEPTIVELY SIMPLE EXCHANGE EFFECTS IN HOMONUCLEAR HARTMANN-HAHN (HOHAHA) SPECTRA OF PROTEIN-LIGAND COMPLEXES'**

## Description

The invention relates to a magnetic resonance imaging method for the volume-selective extraction of spectral information from an object containing a first type of nucleus and a second type of nucleus which is coupled to the first type of nucleus, said object being arranged in a steady, uniform magnetic field, the spectral information being extracted from magnetization transfer.

The invention also relates to a magnetic resonance imaging device for the volume-selective extraction of spectral information from an object containing a first type of nucleus and a second type of nucleus which is coupled to the first type of nucleus, which device comprises means for generating a steady, uniform magnetic field, transmitter means for transmitting RF electromagnetic pulses to the object arranged in the steady field, means for generating magnetic field gradients superposed on the steady field, and receiving and processing means for the magnetic resonance signals generated in the object, which processing means include programmed means and are operative to apply, by way of the transmitter means, pulses to the first and the second type of nucleus so that the spectral information is extracted from magnetization transfer.

A magnetic resonance imaging method and device of this kind are known from US 4,922,203. In that method the magnetization transfer is realised in that the volume containing the compound is excited with the first rf pulse having a first frequency to excite $^1$H nuclei in the compound. At least one magnetic field is then applied to the volume to spatially separate the response of the $^1$H nuclei to the first pulse. Whereafter, the volume is excited with a second RF pulse having a second frequency and a phase effective to distinguish the response of a $^{13}$C-coupled $^1$H from $^{12}$C-coupled $^1$H and applied at a time after the first pulse which is the inverse of the coupling constant J. Volume selection is obtained by employing a surface coil.

It is an object of the invention to improve the volume selection of the spectral information.

A method in accordance with the invention is characterized in that the magnetization transfer is realised by heteronuclear Hartmann-Hahn transfer, the spectral information of at least one type of nucleus being extracted from transferred magnetization of the other type of nucleus, the heteronuclear Hartmann-Hahn transfer being realised by applying a volume-selective pulse and gradient sequence to the first type of nucleus in order to bring a magnetization of the object volume-selectively out of a state of equilibrium and by subsequently spin-locking the magnetization volume-selectively brought out of the state of equilibrium by means of an RF electromagnetic spin-lock pulse while at the same time applying a cross-polarization transfer pulse to the second type of nucleus. Volume selection can be realised, for example by means of a PRESS, ISIS or STEAM sequence, the spin-lock field being applied at the instant of echo formation. The so-called Hartmann-Hahn transfer or cross-polarization transfer is achieved when the so-called Hartmann-Hahn condition is satisfied:

$$\gamma'.B_1' = \gamma''.B_1''$$

where $\gamma'$ and $\gamma''$ are the gyromagnetic ratios of the first and the second type of nucleus, respectively, and $B_1'$ and $B_1''$ are the RF electromagnetic fields on the first and the second type of nucleus, respectively.

It is to be noted that Hartmann-Hahn transfer is described *per se* in the book "Principles of Nuclear Magnetic Resonance in One and Two Dimensions", R.R. Ernst e.a., Oxford Scientific Publications, 1986, pp. 185-191. Except that the cited book states that the Hartmann-Hahn experiment *per se* imposes severe requirements as regards devices to be used for executing the experiment, it is also noted that other transfer methods are to be preferred for liquids.

The Hartmann-Hahn transfer is also known from the article "Analysis of Multiple-Pulse-Based Heteronuclear J cross Polarization in Liquids" from J. Zuiderweg, Journal of Magnetic Resonance, Vol 89, October 1990, pages 533-542. In that article a Hartmann-Hahn experiment is described to produce efficient heteronuclear cross polarization in liquids over a wide field of RF field mismatches in an analytical NMR spectrometer.

A version of a method in accordance with the invention is characterized in that a the volume-selective pulse and gradient sequence is a localized spin-echo sequence and in that a phase encoding gradient is applied after the cross-polarization transfer pulse and before signal acquisition. *Via* the localized spin-echo sequence, a bar is then selected as the part of the object and at the instant of echo-formation a spin-lock field is applied. The bar is sub-divided by the phase encoding and, after Fourier transformation, a set of spectra is obtained from the bar. The bar can be chosen so as to extend through a heart of an in vivo animal or human object.

Another version of a method in accordance with the invention is characterized in that a single double-tuned coil is used for applying pulses to the respective nuclei. Because the $B_1$ profiles of both fields are then identical, Hartmann-Hahn transfer can be achieved over a comparatively large volume.

A further version of a method in accordance with the invention is characterized in that the first type of nucleus is a proton, the second type of nucleus being a carbon isotope enriched in the object, signal acquisition of magnetization transferred to protons by enriched carbon isotopes then taking place. The sequence in accordance with the invention will generally be used in conjunction with the use of transfer from an abundantly present nucleus such as a proton nucleus, to a nucleus which occurs only rarely, utilizing a "gain" factor which is given by the ratio of the gyromagnetic ratios of the nuclei. In the present example the same transfer mechanism is used, but measurement takes place *via* the channel other than the customary channel, *i.e. via* the proton channel in the present example. However, the nucleus which inherently occurs to a lesser extent in vivo should then be enriched, for example by injection or oral administration in order to achieve adequate signal strength. For example, when the non-toxic glucose is applied in vivo as an enrichment of a $^{13}$C isotope, the metabolism thereof, notably in the brain of the object, can be traced. The latter offers major advantages with respect to so-called PET (Positron Emission Tomography) techniques where radioactive compounds are injected into the object, for example radioactive modified glucose compounds.

The invention will be described in detail hereinafter with reference to a drawing; therein:

Fig. 1 shows diagrammatically a magnetic resonance imaging device in accordance with the invention,
Figs. 2A to 2E show a first version of a pulse and gradient sequence in accordance with the invention as well as its effects, and
Fig. 3 shows a second version of a pulse and gradient sequence in accordance with the invention.

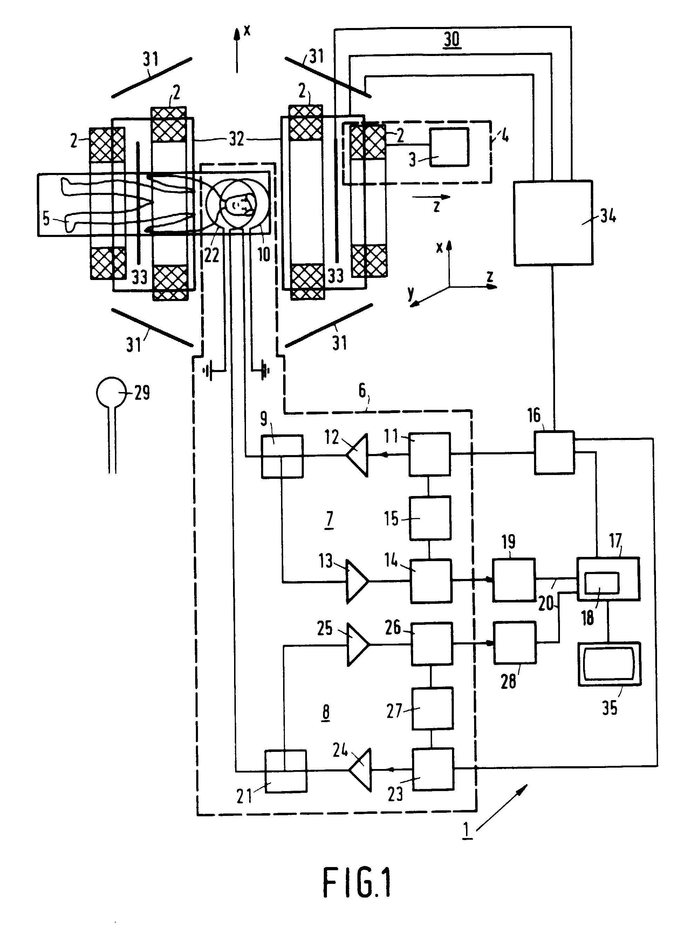

Fig. 1 shows diagrammatically a device 1 in accordance with the invention. The device 1 comprises magnet coils 2 and, in the case of resistive magnets or superconducting magnets, a DC power supply 3. The magnet coils 2 and the DC power supply 3 constitute means for generating a steady, uniform magnetic field. When the magnet coils 2 are constructed as permanent magnets, the DC power supply 3 will be absent. An object 5 can be arranged within the magnet coils 2. The object 5 may contain nuclear spins of a first type of nucleus and of a second type of nucleus which may be coupled to one another, for example in a $CH_n$ group of a molecule in which C is a $^{13}$C carbon isotope and H is a $^{1}$H proton. Other types of nuclei are also feasible. The coupling can then be expressed by a coupling constant $J_{CH}sec^{-1}$. During operation of the device 1 with the object 5, which may be an in vivo human or animal object, being arranged within the magnet coils 2, a slight excess of nuclear spins (of nuclei having a magnetic moment) will be directed in the direction of the steady field in a state of equilibrium. From a macroscopic point of view this is to be considered as an equilibrium magnetization. The device 1 furthermore comprises means 6 for generating magnetic resonance signals in the body by means of RF electromagnetic pulses. The means 6 comprise a first transmitter/receiver channel 7 and a second transmitter/receiver channel 8. The first transmitter/receiver channel 7 is coupled, *via* a directional coupler 9, to a first coil 10 for the transmission of RF electromagnetic pulses and for the reception of magnetic resonance signals.

The first transmitter/receiver channel comprises a modulator 11, an amplifier 12, an amplifier 13, a phase-sensitive detector 14 and an oscillator 15 for generating a carrier signal. The modulator 11 may be an amplitude and/or frequency and/or phase modulator and is controlled by a process computer 16 which is coupled to processing means 17 which include programmed means 18. A magnetic resonance signal received *via* the first transmitter/receiver channel 7 is demodulated in the phase-sensitive detector 14 and the demodulated signal is applied to an A/D converter. Sampling values 20 can be applied to the processing means 17. The construction of the second transmitter/receiver channel 8 is identical and comprises a directional coupler 21, a transmitter/receiver coil 22, a modulator 23, an amplifier 24, an amplifier 25, a phase-sensitive detector 26, and an oscillator 27. The phase-sensitive detector 26 is coupled to an A/D converter 28 which itself is coupled to the processing means 17. When the device 1 is used to generate pulse and gradient sequences for realising magnetization transfer from a first type of nucleus to a second type of nucleus coupled to the first type of nucleus, the oscillator 15 will be adjusted to the spin rsonance of the first type of nucleus and the oscillator 27 will be adjusted to the spin resonance of the second type of nucleus. The coils 10 and 22 can be replaced by a surface coil 29 which may be a single double-tuned coil tuned to the respective resonant frequencies of the respective nuclei. In the latter case this coil is connected to the directional couplers 9 and 21 *via* a customary frequency separation filter for separating the respective resonant frequencies of the two types of nuclei. The coils 10 and 22 may alternatively be formed by a double concentrically arranged coil which thus enables volume selection. When use is made of surface coils, such coils will be displaceable within the device 1. The device 1 also comprises means 30 for generating magnetic field gradients superposed on the steady field. The means 30 comprise gradient magnet coils 31 for generating a magnetic field gradient $G_x$, gradient magnet coils 32 for generating a magnetic field gradient $G_y$, gradient magnet coils 33 for generating a magnetic field gradient $G_z$, and a power supply 34 which is controlled by the process computer 16 and which serves to power the gradient magnet coils 31, 32 and 33 which are individually activatable. In the embodiment shown the gradient magnet coils 31, 32 and 33 are arranged in space so that the field direction of the magnetic field gradients $G_x$, $G_y$ and $G_z$ coincides with the direction of the steady field and that the gradient directions extend perpendicularly to one another as denoted by three mutually perpendicular axes x, y and z in Fig. 1. The device 1 furthermore comprises display means for displaying spectra to be formed from resonance signals received. The programmed means 18 are operative to determine, for example by way of a Fourier transformation, spectra from the sampling values 20, for example obtained *via* the second transmitter/receiver channel 8.

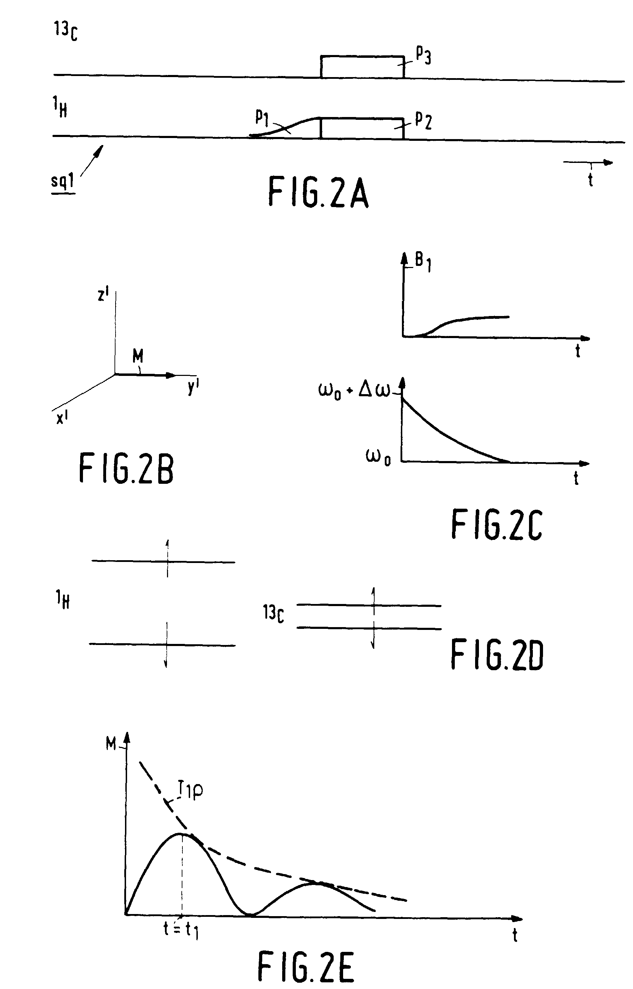

Fig. 2A shows a first version of a pulse and gradient sequence sq1 in accordance with the invention as a function of time t, volume selection being realised by means of the coils 10 and 22 which are constructed as surface coils. By way of example it will be assumed that the first type of nucleus is a bound proton $^1$H, coupled to a $^{13}$C carbon isotope. The coils 10 and 22 may be concentric coils, the coil 10 being coupled to the transmitter/receiver channel 7 and being tuned to $^1$H, while the coil 22 is coupled to the transmitter/receiver channel 8 and tuned to $^{13}$C. In accordance with the invention, *via* the channel 7, being the proton channel, an adiabatic pulse $p_1$ is applied which, in the case of a so-called 90° adiabatic pulse, brings an equilibrium proton magnetization volume-selectively into a transverse state. This is shown in Fig. 2B in a rotating proton coordinate system x', y' and z' with the magnetization M. In the case of an adiabatic pulse, the modulator 11 in the proton channel is an amplitude/frequency modulator. Fig. 2C shows the variation of the RF field $B_1$ in the case of an adiabatic pulse as a function of time t with simultaneous variation of the frequency, varying from $\omega_0+\Delta\omega$ to $\omega_0$, *i. e.* with a frequency swing $\Delta\omega$ about the proton resonant frequency $\omega_0$. Subsequently, *via* the proton channel 7 a spin-lock pulse $p_2$ is applied to the object 5 under the control of the programmed means 18. The $B_1$ field of the spin-lock pulse $p_2$ should then be directed along the same axis as the magnetization M. During the spin-lock pulse $p_2$ a cross-polarization transfer pulse $p_3$ is applied to the object 5 *via* the $^{13}$C channel 8. After termination of the pulses $p_2$ and $p_3$, a resonance signal 20 is sampled in the proton channel 7 and processed in the processing means 17, using Fourier transformation, so as to obtain a spectrum. Due to the transfer a carbon magnetization is observed which has been intensified by the ratio of the gyromagnetic ratios of protons and the carbon isotope coupled thereto, *i.e.* by a "gain" factor 4. In this respect it is important that the so-called Hartmann-Hahn condition is satisfied, *i.e.* in the present example the $B_1$ fields should relate as 1:4.

Fig. 2D shows Zeeman splitting of energy levels in the steady field for $^1$H and $^{13}$C, spin-up and spin-down also being diagrammatically shown therein. The Hartmann-Hahn transfer condition implies that the energy gradients should correspond, *i.e.* the spin-locked system can transfer energy only subject to the Hartmann-Hahn condition. In that case the transfer is "smooth", in this respect it is to be noted that a perturbance term should be present in liquid. In the relevant example this perturbance term is present in the form of a J-coupling between $^1$H and $^{13}$C, the speed of transfer being proportional to this coupling constant, *i.e.* the time required for the cross-polarization transfer is inversely proportional to the J-coupling. Proton-carbon couplings are comparatively great (125-170 Hz), so that cross-polarization transfer times of from 4 to 7 ms suffice.

Fig. 2E shows the behaviour of transferred transverse magnetization M as a function of time t. It appears that the transfer is an oscillatory reciprocal process. The magnetization transferred can be sampled at the first maximum at the instant $t = t_1 = 1/J$. In an absolute sense the magnetization decreases due to relaxation which is inherently present; in the present example this is the relaxation of fat in a rotating system of coordinates, $T_{1\rho}$, amounting to about 300 ms. For example, when a glycogen coupling is considered, the relaxation in the rotating system of coordinates is about two orders of magnitude smaller than that of fat. In that case signal acquisition should take place prior to the first magnetization peak, as shown in Fig. 2E, in order to obtain an optimum result. In a human object 5 glycogen occurs notably in muscular tissue and the liver and can provide an indication as regards the energy conditions in the object. A deviating glycogen concentration will be found in the case of metabolic disorders.

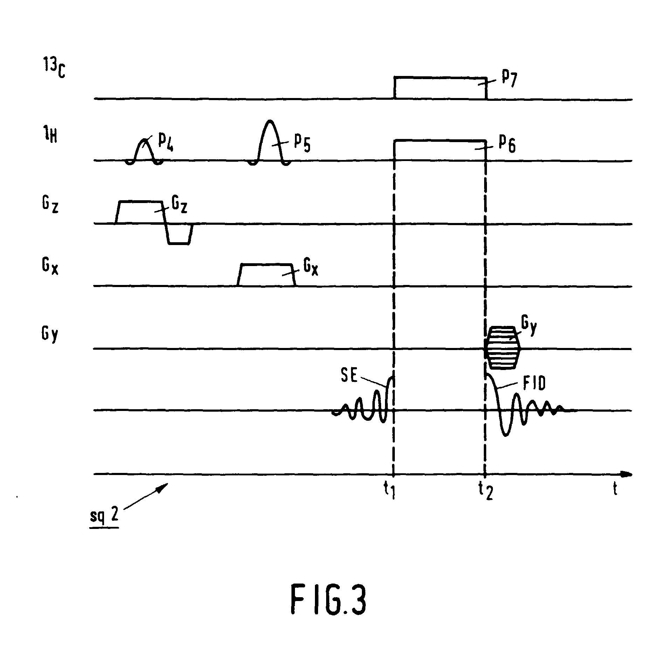

Fig. 3 shows a second version of a pulse and gradient sequence sq2 in accordance with the invention as a function of time t. *Via* the first channel 7, for example the proton channel $^1$H, a localized spin-echo sequence is applied which comprises a localized excitation pulse $p_4$ having a gradient $G_z$ and also a localized inversion pulse $p_5$ having a gradient $G_x$. At the instant $t = t_1$, at the maximum of the spin-echo signal SE, a spin-lock pulse $p_6$ is applied to the object 5, a cross-polarization transfer pulse $p_7$ being applied at the same time *via* the channel 8, for example the $^{13}$C channel. As a result, a transferred resonance signal FID localized in a bar is obtained. By application of a phase encoding gradient $G_y$ immediately after termination of the spin-lock, resonance signals are obtained from parts of the bar, it being possible to reconstruct spectra therefrom by means of the programmed means 18.

In other versions, a volume-selective pulse and gradient sequence such as PRESS, ISIS or STEAM is first applied to the first type of nucleus, thus bringing the magnetization volume-selectively out of equilibrium. Subsequently, Hartmann-Hahn transfer to the second type of nucleus takes place. In the case of a PRESS sequence as described in European Patent Application No. 0 106 226 and a STEAM sequence as described in United States Patent no. 4,748,409, spin-locking is applied at the maximum of the volume-selective echo resonance signal or the stimulated spin-echo signal, respectively. The excitation pulses are then spatially selective and no magnetic gradient is applied during the occurrence of the volume-selective resonance signal. In the case of the ISIS sequence as described in Journal of Magnetic Resonance 66, 283-294 (1986), volume-selective magnetization is obtained by 8-fold application of pulse and gradient combinations. The ISIS excitation pulse is then preferably an adiabatic 90° pulse and spin-locking is applied during occurrence of a FID signal due to the ISIS excitation pulse.

Because of the reciprocal nature of the Hartmann-Hahn transfer, measurement is also possible *via* the channel which is not the customary channel. In the case of proton-carbon coupling, however, it is then necessary to enrich the carbon in practice, for example by injection or oral administration of glucose to an object 5 whose metabolism can then be traced. Additional phase encoding gradients can then also be applied in order to obtain magnetic resonance signals for a spectroscopic image, for example after the spin-lock pulses and before signal acquisition. The latter method could be an alternative to PET (Positron Emission Tomography) which utilizes radioactive compounds.

**Claims**

1. A magnetic resonance imaging method for the volume-selective extraction of spectral information from an object containing a first type of nucleus and a second type of nucleus which is coupled to the first type of nucleus, said object being arranged in a steady, uniform magnetic field, the spectral information being extracted from magnetization transfer, characterized in that the magnetization transfer is realised by heteronuclear Hartmann-Hahn transfer, the spectral information of at least one type of nucleus being extracted from transferred magnetization of the other ype of nucleus, the heteronuclear Hartmann-Hahn transfer being realised by applying a RF pulse while generating magnetic field gradient superposed on the steady magnetic field to the first type of nucleus in order to bring a magnetization of the object volume-selectively out of a state of equilibrium and by subsequently spin-locking the magnetization volume-selectively brought out of the state of equilibrium by means of an RF electromagnetic spin-lock pulse while at the same time applying a cross-polarization transfer pulse to the second type of nucleus.

2. A magnetic resonance imaging method as claimed in Claim 1, characterized in that the volume-selective pulse and gradient sequence is a PRESS sequence, an ISIS sequences or STEAM sequence.

3. A magnetic resonance imaging method as claimed in Claim 1, characterized in that the volume-selective pulse and gradient sequence is a localized spin-echo sequence, and in that a phase encoding gradient is applied after the cross-polarization transfer pulse and before signal acquisition.

4. A magnetic resonance imaging method as claimed in Claim 1, 2 or 3, characterized in that a single double-tuned coil is used for applying pulses to the respective nuclei.

5. A magnetic resonance imaging method as claimed in any one of the Claims 1 to 4, characterized in that the first type of nucleus is a proton, signal acquisition of magnetization transferred by protons to the second type of nucleus the taking place.

6. A magnetic resonance imaging method as claimed in any one of the Claims 1 to 4, characterized in that a first type of nucleus is a proton, the second type of nucleus being a carbon isotope enriched in the object, signal acquisition of magnetization transferred to protons by enriched carbon isotopes then taking place.

7. A magnetic resonance imaging method as claimed in Claim 6, characterized in that the carbon isotope is enriched by injection or oral administration of glucose.

8. A magnetic resonance imaging device for the volume-selective extraction of spectral information from an object containing a first type of nucleus and a second type of nucleus which is coupled to the first type of nucleus, which device comprises means for generating a steady, uniform magnetic field, transmitter means for transmitting RF electromagnetic pulses to the object arranged in the steady field, means for generating magnetic field gradients superposed on the steady field, and receiving and processing means for the magnetic resonance signals generated in the object, which processing means include programmed means and are operative to apply, by way of the transmitter means, pulses to the first and the second type of nucleus, so that the spectral information is extracted by magnetization transfer, characterized in that the programmed means are also operative to realize the magnetization transfer by means of heteronuclear Hartmann-Hahn transfer, to extract the spectral information of at least one type of nucleus from transferred magnetization of the other type of nucleus, and to realize the heteronuclear Hartmann-Hahn transfer by applying a RF pulse while generating a magnetic field gradient superposed on the steady magnetic field to the first type of nucleus in order to bring a magnetization of the object volume-selectively out of a state of equilibrium and by subsequently spin-locking the magnetization volume-selectively brought out of the state of equilibrium by means of an RF electromagnetic spin-lock pulse while at the same time applying a cross-polarization transfer pulse to the second type of nucleus.

**Patentansprüche**

1. Kernspinresonanz-Abbildungsverfahren für die volumenselektive Extraktion von Spektralinformation aus einem Objekt mit einem ersten Kerntyp und einem zweiten Kerntyp, der mit dem ersten Kerntyp gekoppelt ist, wobei das Objekt in einem statischen homogenen Magnetfeld angeordnet wird, und die Spektralinformation aus der Magnetisierungsübertragung gewonnen wird, <u>dadurch gekennzeichnet,</u> daß die Magnetisierungsübertragung durch heteronukleare Hartmann-Hahn-Übertragung verwirklicht wird, die Spektralinformation wenigstens von einem Kerntyp aus übertragener Magnetisierung des anderen Kerntyps gewonnen wird, die heteronukleare Hartmann-Hahn-Übertragung durch Anlegen eines Hf-Impulses unter Erzeugung eines dem statischen Magnetfeld überlagerten Magnetfeldgradienten zum ersten Kerntyp und durch anschließendes Spinverriegeln der volumenselektiv aus dem Gleichgewichtszustand gebrachten Magnetisierung mit Hilfe eines elektromagnetischen Hf-Spinverriegelungsimpulses verwirklicht wird, während gleichzeitig ein Kreuzpolarisationsübertmgungsimpuls dem zweiten Kerntyp zugeführt wird.

2. Kernspinresonanz-Abbildungsverfahren nach Anspruch 1, <u>dadurch gekennzeichnet,</u> daß die volumenselektive Impuls- und Gradientensequenz eine PRESS-Sequenz, eine ISIS-Sequenz oder eine STEAM-Sequenz ist.

3. Kernspinresonanz-Abbildungsverfahren nach Anspruch 1, <u>dadurch gekennzeichnet,</u> daß die volumenselektive Impuls- und Gradientensequenz eine geortete Spin-Echosequenz ist, und daß ein Phasencodierungsgradient nach dem Kreuzpolarisationsübertragungsimpuls und vor der Signalerfassung zugeführt wird.

4. Kernspinresonanz-Abbildungsverfahren nach Anspruch 1, 2 oder 3, <u>dadurch gekennzeichnet,</u> daß eine einfache doppelabgestimmte Spule zum Zuführen von Impulsen zu den betreffenden Kernen verwendet wird.

5. Kernspinresonanz-Abbildungsverfahren nach einem der Ansprüche 1 bis 4, <u>dadurch gekennzeichnet,</u> daß der erste Kerntyp ein Proton ist, und Signalerfassung der von Protonen auf den zweiten Kerntyp übertragenen Magnetisierung erfolgt.

6. Kernspinresonanz-Abbildungsverfahren nach einem der Ansprüche 1 bis 4, <u>dadurch gekennzeichnet,</u> daß ein erster Kerntyp ein Proton ist, der zweite Kerntyp ein im Objekt angereichertes Kohlenstoffisotop ist, und dabei Signalerfassung der von Protonen durch angereicherte Kohlenstoffisotope übertragenen Magnetisierung erfolgt.

7. Kernspinresonanz-Abbildungsverfahren nach Anspruch 6, <u>dadurch gekennzeichnet,</u> daß das Kohlenstoffisotop durch Einspritzung oder durch orale Verabreichung von Glykose angereichert wird.

8. Kernspinresonanz-Abbildungsanlage für die volumenselektive Extraktion von Spektralinformation aus einem Objekt mit einem ersten Kerntyp und einem zweiten Kerntyp, der mit dem ersten Kerntyp gekoppelt ist, wobei die Anlage Mittel zum Erzeugen eines statischen homogenen Magnetfelds, Sendermittel zum Übersenden elektromagnetischer Hf-Impulse zu dem im statischen Feld angeordneten Objekt, Mittel zum Erzeugen dem statischen Feld überlagerter Magnetfeldgradienten und Empfangs- und Bearbeitungsmittel für die im Objekt erzeugten Magnetresonanzsignale enthält, wobei die Bearbeitungsmittel programmierte Mittel enthalten und zum Zuführen von Impulsen zu den ersten und den zweiten Kerntyp mit Hilfe der Sendermittel betreibbar sind, so daß die Spektralinformation durch Magnetisierungsübertragung gewonnen wird, <u>dadurch gekennzeichnet,</u> daß die programmierte Mittel ebenfalls zum Verwirklichen der Magnetisierungsübertragung mit Hilfe der heteronuklearen Hartmann-Hahn-Übertragung betreibbar ist, um die Spektralinformation wenigstens eines Kerntyps aus übertragener Magnetisierung des anderen Kerntyps abzuleiten, und um die heteronukleare Hartmann-Hahn-Übertragung durch Anlegen eines Hf-Impulses unter Erzeugung eines dem statischen Magnetfeld überlagerten Magnetfeldgradienten zum ersten Kerntyp, um eine Magnetisierung des Objektes volumenselektiv aus einem Gleichgewichtszustand zu bringen, und durch anschließendes Spinverreigeln der volumenselektiv aus dem Gleichgewichtszustand mit Hilfe eines elektromagnetischen Hf-Spinverriegelungsimpulses gebrachten Magnetisierung, während gleichzeitig ein Kreuzpolarisationsübertrungsimpuls an den zweiten Kerntyp gelegt wird.

**Revendications**

1. Procédé de production d'images par résonance magnétique pour l'extraction sélective en volume de l'information spectrale d'un objet contenant un premier type de noyau et un deuxième type de noyau qui est couplé au premier type de noyau, l'objet étant disposé dans un champ magnétique statique uniforme, l'information spectrale étant extraite du transfert de magnétisation, caractérisé en ce que le transfert de magnétisation est réalisé par un transfert de Hartmann-Hahn hétéronucléaire, l'information spectrale d'au moins un type de noyau étant extraite de la magnétisation transférée de l'autre type de noyau, le transfert de Hartmann-Hahn hétéronucléaire étant réalisé en appliquant au premier type de noyau une impulsion de radiofréquence pendant qu'est engendré un gradient de champ magnétique superposé au champ magnétique statique afin d'amener une magnétisation de l'objet sélectivement en volume hors d'un état d'équilibre et ensuite en verrouillant le spin de la magnétisation amenée sélectivement en volume hors de l'état d'équilibre à l'aide d'une impulsion électromagnétique de radiofréquence de verrouillage de spin tout en appliquant simultanément une impulsion de transfert de polarisation croisée au deuxième type de noyau.

2. Procédé de production d'image par résonance magnétique suivant la revendication 1, caractérisé en ce que la séquence d'impulsion et de gradient sélective en volume est une séquence PRESS, une séquence ISIS ou un séquence STEAM.

3. Procédé de production d'image par résonance magnétique suivant la revendication 1, caractérisé en ce que la séquence d'impulsion et de gradient sélective en volume est une séquence d'écho de spin localisé et en ce qu'un gradient de codage de phase est appliqué après l'impulsion de transfert de polarisation croisée et avant l'acquisition du signal.

4. Procédé de production d'image par résonance magnétique suivant la revendication 1, 2 ou 3, caractérisé en ce qu'une bobine unique doublement accordée est utilisée pour appliquer les impulsions aux noyaux respectifs.

5. Procédé de production d'image par résonance magnétique suivant l'une quelconque des revendications 1 à 4, caractérisé en ce que le premier type de noyau est un proton, l'acquisition du signal de la magnétisation transféré par les protons au second type de noyau ayant alors lieu.

6. Procédé de production d'image par résonance magnétique suivant l'une quelconque des revendications 1 à 4, caractérisé en ce que le premier type de noyau est un proton, le deuxième type de noyau étant un isotope de carbone enrichi dans l'objet, l'acquisition de signal de la magnétisation transférée aux protons par les isotopes de carbone enrichis ayant alors lieu.

7. Procédé de production d'image par résonance magnétique suivant la revendication 6, caractérisé en ce que l'isotope du carbone est enrichi par injection ou administration orale de glucose.

8. Dispositif de production d'image par résonance magnétique pour l'extraction sélective en volume de l'information spectrale d'un objet contenant un premier type de noyau et un deuxième type de noyau qui est couplé au premier type de noyau, lequel dispositif comprend des moyens pour engendrer un champ magnétique statique uniforme, des moyens de transmission pour transmettre des impulsions électromagnétiques de radiofréquence à l'objet disposé dans le champ statique, des moyens pour engendrer des gradients de champs magnétiques superposés au champ statique, et des moyens de réception et de traitement pour les signaux de résonance magnétique engendrés dans l'objet, lesquels moyens de traitement comprennent des moyens programmés et sont à même d'appliquer, par l'intermédiaire des moyens de transmission, des impulsions au premier et au deuxième types de noyau de façon que l'information spectrale soit extraite par transfert de magnétisation, caractérisé en ce que les moyens programmés sont également à même de réaliser les transferts de magnétisation à l'aide du transfert de Hartmann-Hahn hétéronucléaire pour extraire l'information spectrale d'au moins un type de noyau à partir de la magnétisation transférée de l'autre type de noyau et d'opérer le transfert de Hartmann-Hahn hétéronucléaire en appliquant une impulsion de radiofréquence tandis qu'est engendré un gradient de champ magnétique superposé au champ magnétique statique au premier type de noyau afin d'amener une magnétisation de l'objet sélectivement en volume hors d'un état d'équilibre et ensuite en verrouillant le spin de la magnétisation amenée sélectivement en volume hors de l'état d'équilibre à l'aide d'une impulsion électromagnétique de radiofréquence de verrouillage de spin tout en appliquant simultanément une impulsion de transfert de polarisation croisée au deuxième type de noyau.

FIG.1

FIG.2A

FIG.2B

FIG.2C

FIG.2D

FIG.2E

FIG.3